# EUROPEAN PATENT APPLICATION

(11) **EP 4 513 668 A1**
(43) Date of publication of application: **26.02.2025**
(21) Application number: 23425040.5
(22) Date of filing: 21.08.2023
(51) Int. Cl.: H01P 5/08, H01R 24/50

(54) **ADDITIVE MANUFACTURED COAX-LIKE CONNECTION FOR MICROSTRIP ANTENNA FEEDING AND SIGNAL INTEGRITY IN HIGH FREQUENCY PCB**

(71) Applicant: Rockwell Collins, Inc., Cedar Rapids, IA 52498 (US)
(72) Inventor: Manica, Luca, 38062 Arco (TN) (IT); Tiana, Carlo L., Goldendale, WA 98620 (US)
(74) Representative: Dehns

(57) **Abstract**

A printed circuit board "PCB" comprising a coaxial-like connection (210) is described herein. The coaxial-like connection (210) is configured to transmit a radio frequency signal or signals. The PCB can be used in combination with an antenna.

## Description

### FIELD

The examples described herein relate to the technical field of electrical connections in PCB such as microstrip lines that are used for feeding patch antennas.

### BACKGROUND

Microstrip patch antennas used in Printed Circuit Boards (PCB) are typically fed using microstrip lines, vias or apertures, however, at high frequencies all those techniques introduce high power losses and are susceptible to internal (i.e., cross-talk) and external interferences. Additionally, impedance matching using vias is complicated and highly impacted by manufacturing tolerances leading to unpredictable antenna system behaviour.

### SUMMARY

A printed circuit board "PCB" is described herein comprising a coaxial-like connection, said coaxial-like connection being configured to transmit a radio frequency "RF" signal or signals.

In some examples, said coaxial-like connection is manufactured via a 3D printing technique or techniques.

In some examples, said coaxial-like connection is manufactured via an additive manufacturing technique.

In some examples, the PCB further comprises an antenna, said antenna comprising: a first dielectric layer having first, upper, surface and an opposite, lower surface, and a metal patch provided on said first, upper, surface of said first dielectric layer, a second dielectric layer having a first, upper surface and a second, opposite, lower surface and a ground plane provided between said second lower surface of said first dielectric layer and said first, upper surface of said second dielectric layer, and said coaxial probe like connection being provided embedded in said ground layer, said coaxial probe like connection being connected to said metal patch, to thereby transmit RF power to said patch in use.

In some examples, said ground plane is in direct contact with said second, lower, surface of said first dielectric layer and in direct contact with said first, upper surface of said second dielectric layer.

In some examples, a connector is provided on and attached to said first, upper surface of said first dielectric layer via a mount connector.

In some examples, said coax-like connection connects the surface mount connector to the metal patch.

In some examples, the PCB further comprises first and second coax pins embedded in said ground plane, said first and second coax pins being configured to receive and output said RF signals in use.

In some examples, said PCB is manufactured via an additive manufacturing technique.

A method of manufacturing a printed circuit board "PCB" is also described herein comprising forming a coax-like connection in said PCB via a 3D printing technique or techniques.

In some examples, the method further comprises forming said coax-like connection via an additive manufacturing technique or techniques.

In some examples, the method may further comprise forming an antenna for said PCB, said method comprising: providing a first dielectric layer having first, upper, surface and an opposite, lower surface, and providing a metal patch 15 on said first, upper, surface of said first dielectric layer, providing a second dielectric layer having a first, upper surface and a second, opposite, lower surface and providing a ground plane provided between said second lower surface of said first dielectric layer and said first, upper surface of said second dielectric layer, and embedding a coaxial probe like connection in said ground layer, and connecting said coaxial probe like connection to said metal patch, to thereby transmit RF power to said patch in use.

In some examples, the method may further comprise providing said ground plane such that it is in direct contact with said second, lower, surface of said first dielectric layer and in direct contact with said first, upper surface of said second dielectric layer.

In some examples, the method may further comprise providing and attaching a connector to said first, upper surface of said first dielectric layer via a mount connector.

In some examples, the method may further comprise connecting said coax-like connection via the surface mount connector to the metal patch.

In some examples, the method may further comprise comprising embedding first and second coax pins in said ground plane, said first and second coax pins being configured to receive and output said RF signals in use.

In some examples, any or all of the method steps are performed via an additive manufacturing technique or techniques.

### BRIEF DESCRIPTION OF THE DRAWINGS

Figure 1a depicts a side view of a prior art microstrip patch antenna
Figure 1b depicts a top view of the prior art microstrip patch antenna of figure 1a.
Figure 2 depicts a metal patch antenna with coaxial probe feed.
Figure 3 depicts a metal patch antenna with a microstrip line feed.
Figure 4 depicts a metal patch antenna with a proximity coupled feed.
Figure 5 depicts a metal patch antenna with aperture coupled feed.
Figure 6 depicts a microstrip line with a "via" connection.
Figure 7 depicts an example of a new type of feeding design, using a coax-like connection instead of a microstrip.
Figure 8 depicts a connector that may be used in conjunction with the design of figure 7.
Figure 9 depicts a top view of the PCB of figure 7.
Figure 10 shows a 3D view of the PCB of figure 9.
Figure 11 depicts a side, cross sectional, view of the PCB of figures 7, 9 and 10.
Figure 12 depicts how the coax-like connection may be fed into the PCB.

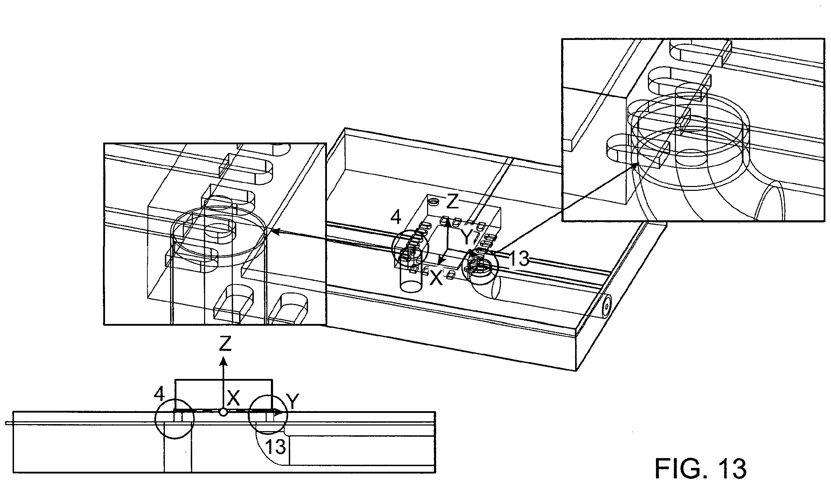

Figure 13 depicts how the coax-like connection may be fed into the PCB.
Figure 14 depicts a top view of a single patch -circular coax-like connection.
Figure 15 depicts side, cross sectional views of the single patch -circular coax-like connection.
Figure 16 depicts a top view of a single patch square coax-like connection.
Figure 17 depicts side views of a single patch square coax-like connection.
Figure 18 depicts a hexagonal patch antenna array.
Figure 19 depicts a hexagonal patch antenna array.

### DETAILED DESCRIPTION

Described herein is a novel method and structure for providing a connection for transmitting radio frequency (RF) signals in a printed circuit board (PCB). This is achieved by providing a PCB using a coaxial-like connection instead of the known connections, as outlined above in the background section. This new type of coaxial-like connection provides a novel way for transmitting RF signals in PCB boards, reducing interferences and impedance mismatch, having broad-band behavior. It is also much more robust to external and on-board interference. This can be manufactured only using 3D printing techniques.

Examples of a new type of electrical connection/electrical feeding means will now be described. These new connecting means may be configured for use between the elements of a printed circuit board (PCB). The connection means has the final appearance of a coaxial-cable embedded in the PCB and it may be used for feeding microstrip patch antennas and in general for carrying high-frequency signals.

In the examples shown and described herein, the connection means may be used for providing an electrical connection to a patch antenna in a printed circuit board (PCB), however, the examples described herein are not limited to being connected to antennas and can be used to connect other electronic components of a PCB.

The new electrical connection means may comprise a coaxial-cable-like connection that may be used for feeding microstrip antennas and in general for carrying high-frequency signals in a PCB board. The coaxial cable connection means consists of an inner conductor surrounded by a conducting shield, with the two separated by an insulating material (dielectric) as for a coaxial cable. Connector dimensions (i.e., diameters) may be selected for matching antenna impedance in the working frequency band. The whole system may be additive manufactured since, at present, it is impossible to build such antennas it using traditional PCB techniques (i.e., lithography). Additionally, using additive manufacturing techniques also means that the final PCB board can take any form (i.e., curvatures) subject to certain physical constraints.

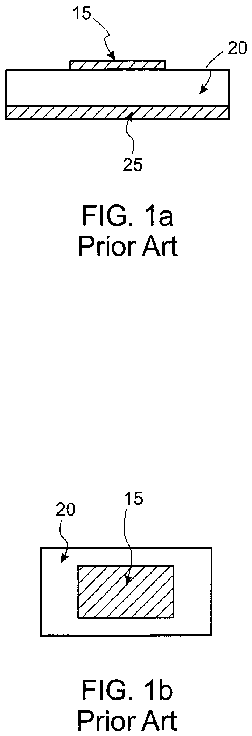

A side view and a top view of a known type of patch antenna is shown in figures 1a and 1b respectively. Such known patch antennas comprise a metal patch 15 that is provided on top of a dielectric substrate 20 and ground plane 25, the dielectric substrate 20 in combination with the ground plane 25 thereby providing a grounded dielectric substrate. Patches 15 can be of different shapes, wherein rectangular and circular are the most common. Patch antennas are the most used antenna typology for cm-wave length spectrum. The dielectric layer 20 is provided between the ground plane, or substrate, 25 and the metal patch antenna 15 as shown in figure 1a.

This type of antenna has various advantages in that it has a low profile and is easy to fabricate (e.g. this can be made via etching and photolithography). It is also easy to feed (e.g. using a coaxial cable, or microstrips) and can be easily integrated into a PCB. The pattern of the metal patch antenna 15 is almost hemispherical and it is easy to use as an element in an antenna array. Patch antennas, however, have some disadvantages also, in that they typically have a low bandwidth, a low efficiency (due to conductors and dielectric losses) and cannot handle a large amount of RF power.

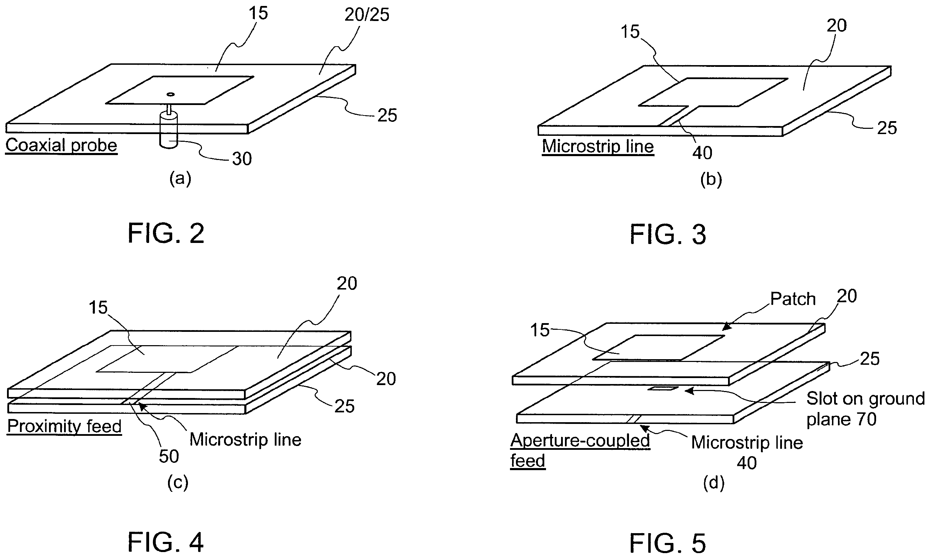

Microstrip patch antennas, in general, have contacting methods which are microstrip line feed methods or coaxial plane feed methods. Non/contacting methods are aperture coupled feed and proximity coupled feed methods. In summary, there are four types of feeding techniques in a microstrip and figures 2 to 5 show these different patch antennae feeding methods. Additionally, table 1 below summarizes feeding technique advantages, indicated by (+) or disadvantages, indicated by (-).

A metal patch antenna with a coaxial probe feed is shown in Figure 2. Again, the metal patch 15, the dielectric substrate 20 and the ground plane 25 are indicated in figure 2. As can be seen, a coaxial probe 30 is provided and shown in figure 2. The coaxial probe 30 feeds the antenna patch 15 in use via a contacting method as mentioned above, i.e. by directly contacting the patch 15 and feeding RF power to the patch 15 via the coaxial probe 30.

A metal patch antenna 15 with a microstrip line feed 40 is shown in figure 3. This is also a contacting method of feeding the antenna. In this type of device, a conducting strip 40 is connected directly to the edge of the microstrip patch 15. The patch 15 is wider than the conducting strip 40. The feed can therefore be etched onto the same dielectric substrate 20 to provide a planar structure as shown in figure 3.

A metal patch antenna 15 with a proximity coupled feed is shown in figure 4. Proximity coupled feed techniques are also called electromagnetic coupling techniques. In such devices, two dielectric substrates 20 are provided and the feed line is provided so as to be positioned between the two substrates as shown in figure 4. The radiating patch 15 is provided on the top of the upper substrate 20. This also uses a microstrip line 40, however, this is a non/contacting method, as the microstrip 40 is not directly touching the patch 15, but instead is embedded in the lower dielectric substrate 20.

Finally, a metal patch 15 with an aperture coupled feed 60 is shown in figure 5. In this example the microstrip line 40 lies on the dielectric substrate 25 and the slot 60 is on the ground plane 35. This is a non-contacting feed method, with the aperture coupled feeding technique, the input signal, or microstrip line 40 couples to the radiating patch 15 through the slot 60 that is provided in the ground plane 25.

In all the examples, the goal of the feeding is to transmit as much RF power as possible to the antenna patch.

**Table 1**

| | Fig2. | Fig. 3 | Fig. 4 | Fig. 5 |
|---|---|---|---|---|
| | Coaxial/probe feed | Microstrip-line feed | Proximity-coupled feed | Slot-coupled feed |
| Spurious feed radiation | (+) Low | (-) High | (+) | (++) |
| | | | Low | Very low |
| Reliability | (-) | (++) | (+) | (+) |
| | Poor - due to soldering | Very good | Good | Good |
| Ease of fabrication | (-) | (+) High | Medium | medium |
| | Low -due to soldering and substrate drilling | | | |
| Bandwidth | Low | Low | Medium | High |
| | | | | |
| Power losses | (+) | (-) | (-) | (-) |
| | Low | Medium/high | Medium/high | Medium/high |
| Disturbances immunity | (+) | (-) | (-) | (-) |
| | High | Low | Low | Low |
| Used in PCB | (-) | (+) | (+) | (+) |
| | No | Yes | Yes | Yes |

As can be seen in table 1, the use of a coaxial probe as a feeding technique has many advantages, but cannot be used, at present, in a PCB. The examples described herein therefore aim to provide a new connection system wherein a coaxial probe feed is compatible for use in a PCB and that also has high reliability and easy fabrication.

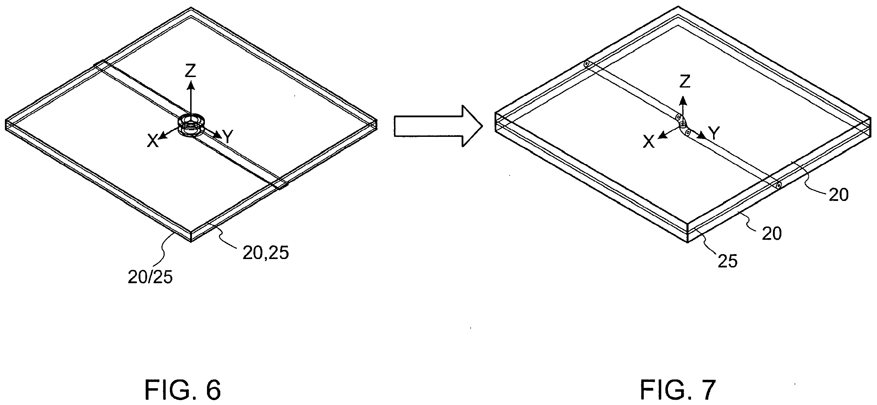

A microstrip line 40 with a "via" connection is shown in figure 6. Such a solution is used in traditional PCB for transmitting signals. In this example, two grounded substrates, each comprising a ground plane 25 associated with a dielectric substrate 20 are provided and the microstrip line 40 is provided between the two grounded substrates.

An example of a new connection, or RF patch feeding design, however, is shown in figure 7, using a coax-like connection instead of the traditionally used microstrip. It can be observed by comparing figures 6 and 7 that the new design provides additional benefits in the PCB design. That is, only a single ground plane 25 is required, as shown in figure 7. The ground plane 20 is provided between a first, upper, dielectric substrate 20 and a second, lower dielectric substrate 20. By reducing the number of ground planes 25 required, the PCB complexity is simplified. The connection impedance control is also simplified since it depends only on the geometrical and physical properties of the connection and not by the surrounding environment (i.e. dielectric thickness and electrical permittivity). The new design also shows low losses because there are no discontinuities due by the via. It also provides protection from external radiations (as the signal is never directly exposed to EMI).

In addition to this, the coax-like connection size may be reduced using dielectric with low permittivity; however, it could be used only for high-speed / antenna feed signal. It is also possible to have coax-like connections of different sizes for easy connection with chips (since the inner connections could potentially be as small as pin size).

Such coax-like connections cannot, at present, be manufactured using traditional (i.e., photolithography) PCB manufacturing techniques. The examples described herein may therefore be created using 3D printing technologies. It has been found that a coax-like connection can be realized using a (1) multi-material, (2) multi-layer 3D printer generating the entire circuit in a (3) single manufacturing step: dielectric and metal parts. In order to achieve this, the technique must be able to deal with both a dielectric and a metal, the structure should be able to build layer by layer and the metal and dielectric must be added during the same manufacturing step.

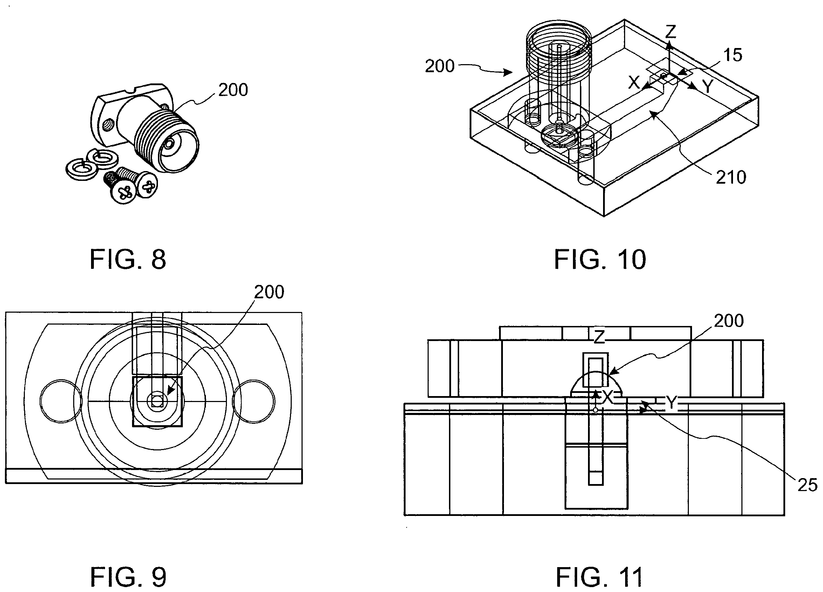

Figures 8 to 10 show how a coaxial connection can be fed into the PCB. Figure 8 depicts a connector 200 that may be used in conjunction with the design of figure 7. In this example, a signal can be launched using a surface mount connector. For example, a 2.92 mm Jack PCB Compression Surface-Mount Connector CON292001-1 may be used. Other types of connectors may also be used as an alternative.

A top view of the PCB of figure 7 is shown in figure 9, wherein the connector pin 200 of figure 8 is attached. The connector pin 200 shall be aligned with the coax inner.

Figure 10 shows a 3D view of the PCB of figure 9. As can be seen, a coax-like connection 210 connects the surface mount connector 200 to the metal patch 15 of the antenna. A front view of this is shown in figure 11. In this figure it can be seen that the connector pin 200 is at the same level as the dielectric layer 20.

Figure 11 depicts a side, cross sectional, view of the PCB of figures 7, 9 and 10. This is a functional block diagram showing the internal connections of the PCB that can be used for the antenna. This can have a working range in the GHz spectrum and in some examples may comprise a Qorvo -cmd297P34 analogue phase shifter.

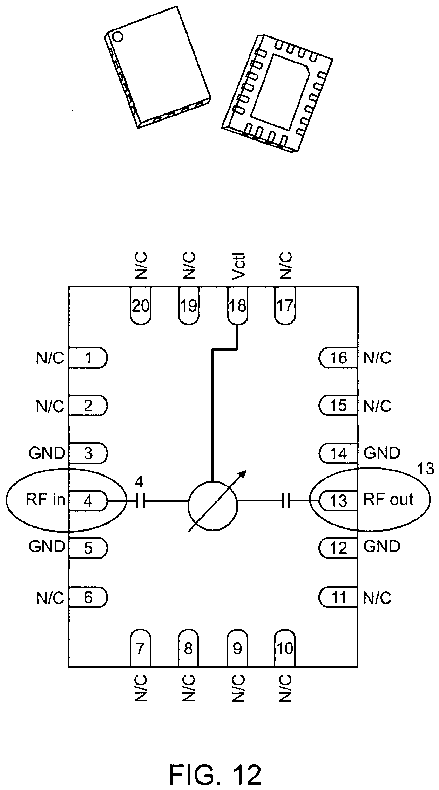

Figure 12 depicts how the coax-like connection may be fed into the PCB. As can be seen in the figure, a first and second coax pins 4, 13, may be provided on the ground plane or substrate 25 by being embedded therein. E coax pins 4, 13 are shown in figure 11. Classical microstrips may be used for connecting DC ground or power signals to the coax pins 4, 13. Such coax like connections can be used for high-frequency signals.

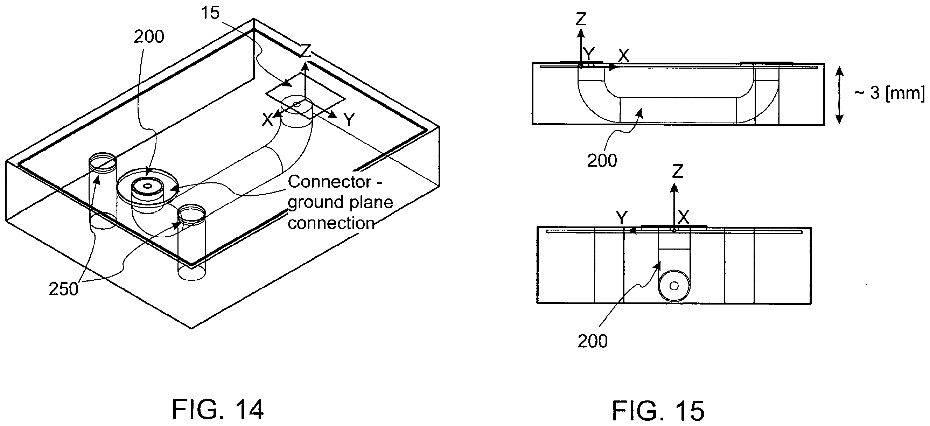

Figure 14 depicts a top view of a single patch -circular coax-like connection. This connection can be designed such that it matches perfectly, or at least almost perfectly to a surface mount connector such as that shown in figure 8. The patch 15 can be seen in figure 14, as well as the coax-like connection which is extending through the ground substrate 25. Holes 250 are also provided for the connectors. In the example the patch 15 has been designed for working in the Ku-band. A side view of the coax-like connection is shown in Figure 14. The depth of the dielectric substrate 25 may be in the region of around a few mm, e.g. 1 to 3mm. However, other design parameters (e.g. substrate thickness and patch size) may be envisaged. Figure 15 shows side, cross sectional views of figure 14.

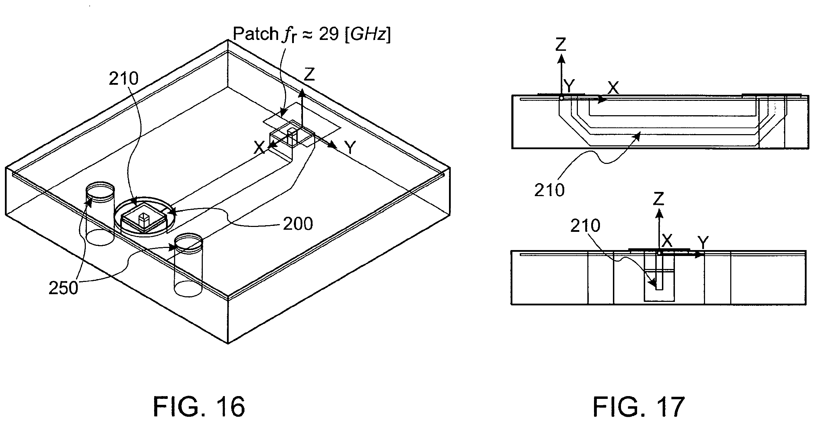

The example shown in figures 16 and 17 again depict a single patch square coax-like connection 210. The same features as discussed above in relation to figures 14 and 15 are provided in these figures too. Such a square coax-like connection can be designed such that it perfectly, or at least almost perfectly matches a surface of the mount connector. This may also be optimised by using 3D printing for its manufacture.

It is possible to have coax like connections of any section shape, however, the square section coax like connection is most suitable for 3D printing.

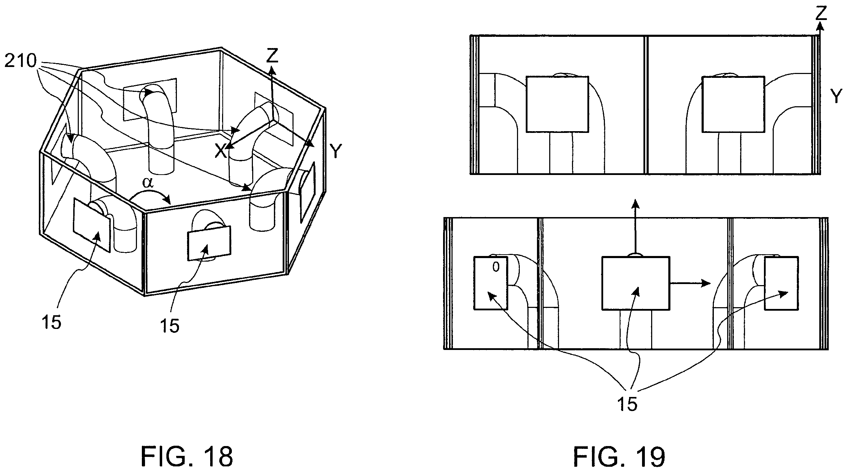

Figure 18 depicts a hexagonal patch antenna array. As can be seen in this figure, there may be provided a plurality of patches 15 around the exterior of the antenna array, each having an individual coaxial connection 210 attached thereto. The dielectric support may be different from the coax dielectric. That is, there are two dielectric parts in the design: (a) the dielectric substrate which the patches are lying on and (b) the dielectric in the coax-like connection. The dielectric is characterized by a physical property called dielectric permittivity (among others). It has an impact on the PCB / coax-like connection design. The fact the dielectric in the coax-like and the PCB are different provides an additional degree of freedom in the design. The examples described herein are also not restricted to using a single dielectric and, in some examples, more than one may be used.

In some examples, a phase shifter may be installed in the bottom (flat part) of the antenna for controlling the array beam. (Typically, a phase shifter has 4 in/out so maybe an octagonal antenna is more appropriated). The 3D printing process can deal with whatever angle α and there would be no need to glue different PCB pieces. Although a hexagonal antenna array is shown in figure 17, other shaped arrays could also be envisaged, using the same concept.

The new antennas described herein have increased robustness with respect to cross-talk and external radiated interferences, because the external conductor shields them. The techniques used also implement an easy feeding (probe-feed) technique for microstrip antennas. Power losses are also reduced during signal transmission. Additionally, the new antennas described herein enable new opportunities for an easier design of conformal radiating systems since they can connect microstrip antennas whatever their orientation. There is also an easier microstrip antenna impedance matching (probe feed), increased signal integrity (high frequency signal) and less shield external interference, cross-talk. The PCB can also be simplified, due to the fact that there is a reduced number of vias and due to the fact that there is no need to place "ground" microstrip lines between high frequency signals. This, in turn, means that it is easier to control the board thickness.

Although this disclosure has been described in terms of preferred examples, it should be understood that these examples are illustrative only and that the claims are not limited to those examples. Those skilled in the art will be able to make modifications and alternatives in view of the disclosure which are contemplated as falling within the scope of the appended claims.

## Claims

1. A printed circuit board "PCB" comprising a coaxial-like connection (210), said coaxial-like connection (210) being configured to transmit a radio frequency signal or signals.

2. The PCB of claim 1 wherein said coaxial-like connection (210) is manufactured via a 3D printing technique or techniques.

3. The PCB of claim 2, wherein said coaxial-like connection (210) is manufactured via an additive manufacturing technique.

4. The PCB of any preceding claim; further comprising an antenna, said antenna comprising:
a first dielectric layer (20) having first, upper, surface and an opposite, lower surface, and a metal patch 15 provided on said first, upper, surface of said first dielectric layer,
a second dielectric layer (20) having a first, upper surface and a second, opposite, lower surface
and a ground plane (25) provided between said second lower surface of said first dielectric layer and said first, upper surface of said second dielectric layer, and
said coaxial probe like connection (210) being provided embedded in said ground layer, said coaxial probe like connection (210) being connected to said metal patch, to thereby transmit RF power to said patch (15) in use.

5. The PCB of claim 4, wherein said ground plane is in direct contact with said second, lower, surface of said first dielectric layer and in direct contact with said first, upper surface of said second dielectric layer.

6. The PCB of any of claims 4 to 5, wherein a connector (200) is provided on and attached to said first, upper surface of said first dielectric layer via a mount connector.

7. The PCB of claim 6, wherein said coax-like connection (210) connects the surface mount connector (200) to the metal patch 15.

8. The PCB of claim 7, further comprising first and second coax pins (4, 13), embedded in said ground plane (25), said first and second coax pins (4, 13) being configured to receive and output said RF signals in use.

9. The printed circuit board of claim 3 wherein said PCB is manufactured via an additive manufacturing technique.

10. A method of manufacturing a printed circuit board "PCB" comprising forming a coax-like connection (210) in said PCB via a 3D printing technique or techniques-

11. The method of claim 10 further comprising forming said coax-like connection (210) via an additive manufacturing technique or techniques.

12. The method of claim 10 or 11 further comprising forming an antenna for said PCB, said method comprising:
providing a first dielectric layer (20) having first, upper, surface and an opposite,
lower surface, and providing a metal patch 15 on said first, upper, surface of said first dielectric layer,
providing a second dielectric layer (20) having a first, upper surface and a second, opposite, lower surface
and providing a ground plane (25) provided between said second lower surface of said first dielectric layer and said first, upper surface of said second dielectric layer, and
embedding a coaxial probe like connection (210) in said ground layer, and
connecting said coaxial probe like connection (210) to said metal patch, to thereby transmit RF power to said patch (15) in use.

13. The method of claim 12, further comprising providing said ground plane such that it is in direct contact with said second, lower, surface of said first dielectric layer and in direct contact with said first, upper surface of said second dielectric layer.

14. The method of any of claims 10 to 13, further comprising providing and attaching a connector (200) to said first, upper surface of said first dielectric layer via a mount connector.

15. The method of claim 14, further comprising connecting said coax-like connection (210) via the surface mount connector (200) to the metal patch (15), and optionally further comprising embedding first and second coax pins (4, 13), in said ground plane (25), said first and second coax pins (4, 13) being configured to receive and output said RF signals in use.
